# EUROPEAN PATENT SPECIFICATION

(11) **EP 4 471 838 B1**
(45) Date of publication and mention of the grant of the patent: **24.06.2026**
(21) Application number: 24177108.8
(22) Date of filing: 21.05.2024
(51) Int. Cl.: H10P 72/10, H10P 72/76, H10P 72/78

(54) **WAFER HANDLING ASSEMBLY**
WAFER-HANDLING-BAUGRUPPE
ENSEMBLE DE MANIPULATION DE PLAQUETTES

(30) Priority: 24.05.2023 US 202363468613 P
(43) Date of publication of application: 04.12.2024
(73) Proprietor: ASM IP Holding B.V., 1322 AP Almere (NL)
(72) Inventor: GARSSEN, Adriaan, 1322 AP Almere (NL)
(74) Representative: V.O.

(56) References cited:
- US-A1- 2010 058 982
- US-A1- 2015 270 150

## Description

### FIELD OF INVENTION

The present disclosure relates to wafer handling in semiconductor processing. More specifically, it relates to a wafer handling assembly comprising a wafer boat and an end effector.

### BACKGROUND OF THE DISCLOSURE

Semiconductor processing involves various processes performed on substrates, such as for example, wafers, that are aligned with one another in order to manufacture the semiconductor devices.

With the advances in semiconductor industry, increase in number of chips produced and increase in throughput may become important factors in order to lower the cost of manufacturing. This may be enabled by processing larger sized substrates and/or processing a plurality of substrates at a time such as for example, in batches.

For some of the processes, the plurality of substrates may be subjected to an increased heat. This may lead to a certain degree of warp to occur at the circumferential edge of the substrates. This may then require a careful handling of such warped substrates in further processes in the manufacturing, particularly when they are treated in batches.

US 2010/058982 A1 discloses a wafer handling assembly of the prior art.

Therefore, there may be a need for an improved handling of substrates.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It may be an object of the present disclosure to provide a wafer handling assembly for improving handling of substrates. It may further be an object of the present disclosure to further improve handling of warped substrates.

In a first aspect, the present disclosure relates to a wafer handling assembly.

The wafer handling assembly may comprise a boat constructed and arranged to hold a plurality of wafers and may have three boat supports per wafers for supporting the wafer in the boat. The wafer assembly may also comprise an end effector. The end effector may comprise three end effector supports for supporting a wafer on the end effector. The three end effector supports may be positioned in substantially the same direction with respect to a center of the three end effector supports as the three boat supports when the center of the end effector is aligned with a center of the three boat supports.

The wafer handling assembly according to embodiments of the first aspect of the present disclosure may allow for increasing the load size. Increased load size may be realized in the boat thanks to the reduced pitch. As such, this may be advantageous in increasing the throughput during processing. This may advantageously lead to reduction in production costs for semiconductor manufacturing

It may further be an advantage that wafer handling may be particularly, for warped wafers.

It may be an advantage that reliability of wafer handling may be increased; such that wafer breakage or cracking may be reduced.

In a second aspect, the present disclosure relates to a semiconductor processing apparatus.

The semiconductor processing apparatus may comprise a process chamber. The process chamber may be constructed and arranged to receive a plurality of wafers. The semiconductor processing apparatus may also comprise a wafer handling assembly, according to embodiments of the first aspect of the present disclosure, for handling the plurality of wafers.

The semiconductor processing apparatus according to embodiments of the second aspect of the present disclosure may contribute to a reduction in semiconductor manufacturing costs thanks to wafer handling provided with increased reliability. This may particularly be advantageous for handling of warped wafers.

It may also be an advantage that thanks to being able to process a plurality of wafers, throughput may be improved.

In a third aspect, the present disclosure relates to a method of processing a plurality of wafers.

The method may comprise providing a plurality of wafers in a process chamber. The provision of the plurality of wafers may comprise handling the plurality of wafers using a wafer handling assembly according to embodiments of the first aspect of the present disclosure.

The method according to embodiments of the third aspect may allow for processing a plurality of wafers. This may, in particular, be advantageous for warped wafers.

It may further be an advantage that the provision and handling of the plurality of wafers may be improved, whereby wafer damage or scrap may be reduced.

### BRIEF DESCRIPTION OF THE DRAWING FIGURES

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure

Like reference numbers will be used for like elements in the drawings unless stated otherwise. Reference signs in the claims shall not be understood as limiting the scope.
Fig. 1a : A schematic top view of the wafer handling assembly according to an embodiment of the first aspect of the present disclosure.
Fig. 1b : A schematic side view of the boat comprised in the wafer handling assembly according to an embodiment of the first aspect of the present disclosure.
Fig. 2 : Tilted top view of an end effector comprised in the wafer handling assembly according to an embodiment of the first aspect of the present disclosure.
Fig. 3 : A schematic side view of a semiconductor processing apparatus according to an embodiment of the second aspect of the present disclosure.
Fig. 4 : A flowchart of an exemplary method according to an embodiment of the third aspect of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride and silicon carbide.

As examples, a substrate in the form of a powder may have applications for pharmaceutical manufacturing. A porous substrate may comprise polymers. Examples of workpieces may include medical devices (for example, stents and syringes), jewelry, tooling devices, components for battery manufacturing (for example, anodes, cathodes, or separators) or components of photovoltaic cells, etc.

A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form.

Non-limiting examples of a continuous substrate may include a sheet, a non-woven film, a roll, a foil, a web, a flexible material, a bundle of continuous filaments or fibers (for example, ceramic fibers or polymer fibers). Continuous substrates may also comprise carriers or sheets upon which non-continuous substrates are mounted.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. The scope of the invention is defined by the appended claims. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present invention is only defined by the appended claims.

Reference throughout the specification to "embodiments" in various places are not necessarily all referring to the same embodiment, but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments, but may.

Reference throughout this specification to "one embodiment" or "an embodiment" means that a particular feature, structure, or characteristic described in connection with the embodiment is included in at least one embodiment of the present disclosure. Thus, appearances of the phrases "in one embodiment" or "in an embodiment" in various places throughout this specification are not necessarily all referring to the same embodiment, but may.

It is to be noticed that the term "comprising", as used herein, should not be interpreted as being restricted to the means listed thereafter. It does not exclude other elements or steps. It is thus, to be interpreted as specifying the presence of the stated features, steps or components as referred to. However, it does not prevent one or more other steps, components, or features, or groups thereof from being present or being added.

The terms first, second, third, and the like in the description and in the claims, are used for distinguishing between similar elements. They are not necessarily used for describing a sequence, either temporally, spatially, in ranking, or in any other manner. It is to be understood that the terms so used are interchangeable under appropriate circumstances and that the embodiments of the disclosure described herein are capable of operation in other sequences than described or illustrated herein.

The following terms are provided only to help in the understanding of the disclosure.

As used herein and unless provided otherwise, the term *"warped substrate or a warped wafer"* may refer to substrates or wafers having a deviation of their geometry from their initial state of flatness.

As used herein and unless provided otherwise, the term *"wafer load or load size"* may refer to the total number of wafers that can be receivable in the boat.

As used herein and unless provided otherwise, the term *"central portion of the wafer"* may refer to a portion of the wafer that may be covered extending away from its center by at least 2/3 of its radius.

As used herein and unless provided otherwise, the term *"exhaust gas"* may refer to the gas after processing is completed in the process chamber.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

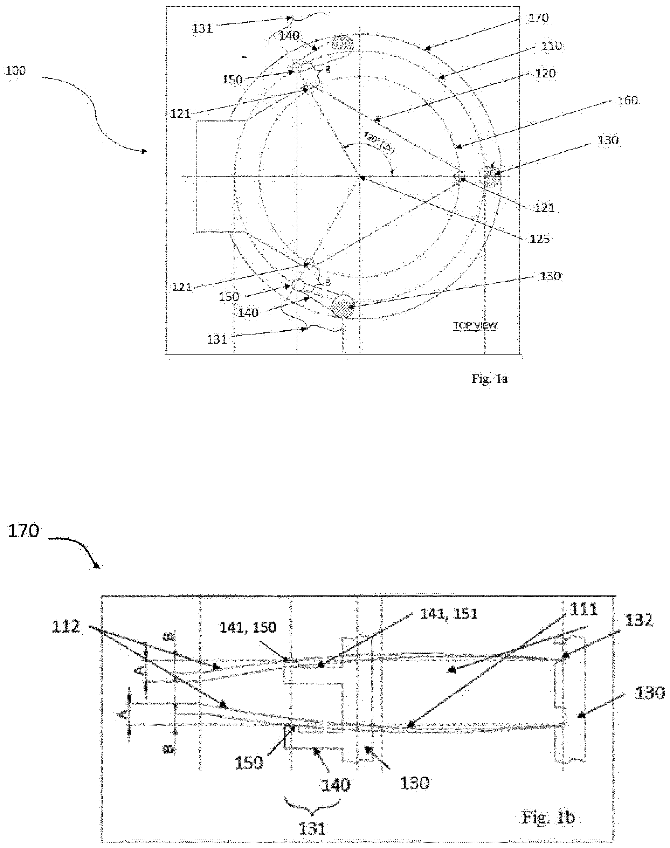

Fig. 1a shows a schematic top view of the wafer handling assembly according to an embodiment of the first aspect of the present disclosure. Fig. 1b shows a schematic side view of the boat comprised in the wafer handling assembly according to an embodiment of the first aspect of the present disclosure.

The wafer assembly (100) may comprise a boat (170). The boat (170) may be constructed and arranged to hold a plurality of wafers (110). Thus, the boat may be referred to as a wafer boat. The boat (170) may have three boat supports (130, 131) per wafer (110). The three boat supports may be suitable for supporting the wafer (110) in the boat (170). The boat may extend in a longitudinal direction, thereby being able to hold the plurality of wafers.

The wafer assembly (100) may also comprise an end effector (120). The end effector (120) may comprise three end effector supports (121). The end effector supports (121) may be suitable for supporting a wafer (110) on the end effector (120). The three end effector supports (121) may be positioned in substantially the same direction with respect to a center of the three end effector supports as the three boat supports (130, 131) when the center (125) of the end effector (120) is aligned with a center of the three boat supports (130, 131).

The wafer assembly (100) may provide the advantage that the end effector supports (121) and the boat supports (130, 131) are as close to each other as possible when the center (125) of the end effector (120) is aligned with a center of the three boat supports (130, 131). This may provide for an improved handling of wafers. The improved handling may thus, be due to the fact that it minimizes the movement of the wafer during transfer from and to the boat (170).

This may particularly be advantageous when handling warped wafers (111). The support provided by the boat (170) comprised in the assembly (100) may help to accommodate wafers, particularly warped wafers (111) in the process chamber, while the end effector (120) may provide ease of handling and transferring of such wafers (111) from and to the boat (170).

It may thus, be an advantage that reliability of wafer handling is improved; such that wafer damage, wafer breakage or wafer cracking may be reduced during transfer from and to the boat (170) and while being held in the boat (170) in the process chamber.

It may be an advantage that higher wafer loads may be realized in the boat (170) thanks to the reduced pitch. The pitch may be reduced thanks to the three boat supports for wafer that are suitable for supporting the wafer. The reduced pitch may advantageously enable a higher throughput during processing. This may advantageously lead to a reduction in production costs for semiconductor manufacturing.

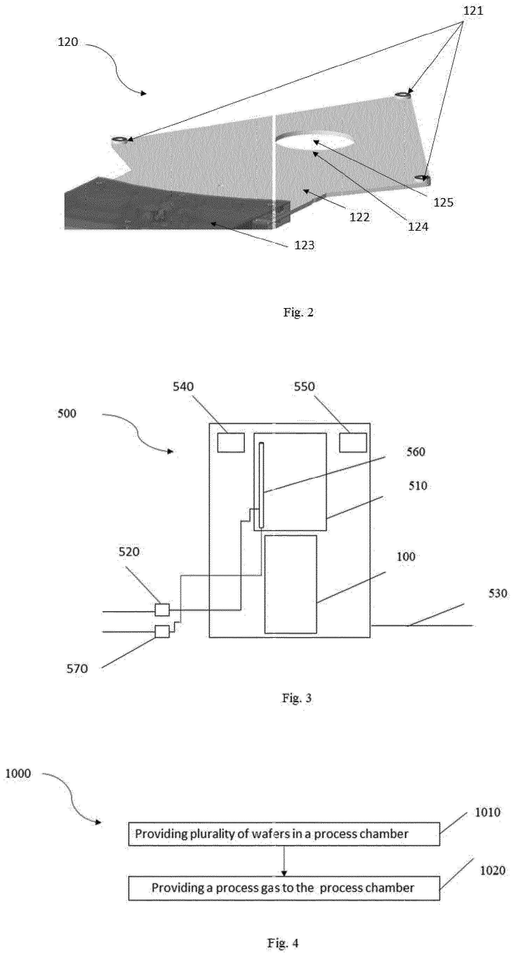

Fig. 2 shows a tilted top view of an end effector (120) comprised in the wafer handling assembly (100) according to an embodiment of the first aspect of the present disclosure.

In embodiments, the three end effector supports (121) may form an end effector support plane (122). The three end effector supports (121) may be substantially equally separated from one another in the end effector support plane (122). The end effector support plane (122) may provide the advantage of supporting the wafer when handling the wafer (110).

The substantial equal separation of the three end effector supports (121) may allow for providing a reliable grip to the wafer (110) when the wafer is being transferred from and to the boat (170). The reliable grip may account for an equibalanced placement of the wafer on the end effector support plane (122). Furthermore, the substantial equal separation of the three end effector supports (121) may be advantageous in providing a radially balanced support to the wafer (110). Depending on how far the three end effector supports (121) are positioned away from the center (125) of the three end effector supports (121), the balanced support may be provided to a central portion of the wafer, to a circumferential edge of the wafer or anywhere in between the central portion and the circumferential edge. The three end effector supports (121) may thus, be positioned within the end effector support plane (122) so as to optimize or, in other words, improve the grip of the wafer when a wafer is being transferred from and to the boat (170) by the end effector (120).

Thus, in some embodiments, the three end effector supports (121) may be constructed and arranged to support the central portion of the wafer (110).

On the other hand, support at the central portion may be advantageous particularly when handling wafers that are already warped. Since warped wafers may be concave-shaped or convex-shaped, support provided at the central portion may be advantageous.

In embodiments, the three end effector supports (121) may be positioned in directions as far separated from each other in said end effector support plane (122) as possible. Thus, the three end effector supports (121) may be positioned in directions separated from each other in a range of 110° to 130°.

In some embodiments, the three end effector supports (121) may be positioned in directions substantially separated 120 degrees from each other in said end effector support plane (122) with respect to a center (125) of the three end effector supports (121). This may allow for a more balanced grip to the wafer (110) when the wafer is being transferred from and to the boat (170) since the wafer is typically substantially circular. This may further be advantageous when handling any size of wafers. It may further be advantageous when handling any size of warped wafers.

In embodiments, there may be a cut-out in the center (125) of the end effector support plane (122) (Fig. 2). This may allow for handling warped wafers, where the warpage is in the form of a bowl-shape.

In embodiments, a height of the three end effector supports (121) may be configured such that a clearance is formed between the wafer and the end effector support plane (122) so that the wafer is prevented from coming into contact with the end effector support plane (122) when the wafer is supported on the end effector (120).

It is to be noted that the height of the three end effector supports (121) may be a design value that can be optimized depending on the warpage expected to be obtained after the processing in a semiconductor processing apparatus, thereby allowing a safer handling of the wafer during transfer from and to the boat (170).

It is further noted that the height of the three end effector supports (121) may be a design value that can be optimized depending on the existing warpage that the wafer may have, thereby also thereby allowing a safer handling of the wafer during transfer from and to the boat (170).

In embodiments, the height of each of the three end effector supports (121) may be in a range of 1 mm to 3 mm. In some embodiments, the height may be about 2 mm.

In embodiments, each of the three end effector supports (121) may be provided with vacuum suction in order to detect the wafer. This may be advantageous when handling warped wafers, in particular, as these kind of wafers do not have a flat surface. The vacuum suction may be provided from the center of each of the three end effector supports (121). The vacuum suction may also be provided from a circumferential edge of each of the three end effector supports (121). It is further to be noted that the end effector supports provided with vacuum suction may further be used for gripping the wafer or for detecting wafer presence.

In embodiments, the three boat supports (130, 131) may form a boat support plane (160). The three end effector supports (121) may substantially be equally separated from one another in the boat support plane (160). The boat support plane (160) may thus, be advantageous in accommodating the wafer (110) in the boat (170). Furthermore, the end effector (120) may be receivable within the boat support plane (160) when transferring the wafer (110) in the boat (170). Thus, the end effector (120) may fit in the boat support plane (160).

In embodiments, the three boat supports (130,131) may be positioned in directions substantially separated 120 degrees from each other in the boat support plane (160) with respect to a center of the three boat supports (130, 131). This may allow for providing an equibalanced positioning of each of the plurality of wafers (110) in the boat (170). This may particularly be advantageous when dealing with warped wafers. This may further be advantageous when dealing with larger sized wafers such as for example, 300 mm wafers or 450 mm wafers.

In embodiments, two (131) of the three boat supports (130,131) may be side boat supports. In other words, two (131) of the boat supports may be positioned on sideways of the boat (170). Thus, the two boat supports (131) may substantially be facing each other. Each of the two (131) side boat supports may comprise a wafer support structure (140) having an upper surface (141). The support structures (140) may be protruding from each of the two side boat supports (131) as schematically shown in Fig. 1a and Fig. 1b. The support structures (140) may protrude from the two side boat supports (131) positioned away from the center of the respective side boat support 131 and in a converging direction with one another. This may provide an equibalanced support for the wafer. This may particularly be advantageous when the wafer is a warped wafer or a larger sized wafer.

The upper surface (141) of the wafer support structure (140) may refer to the surface of the wafer support structure (140) that faces a surface of the wafer opposite to the surface on which integrated circuit components are built. A peripheral portion (150) of the upper surface (141) may be raised relative to a main portion (151) of the upper surface (141). The raised portion may be suitable for supporting an edge of the wafer (110). The edge supported by the raised portions (150) of the two boat supports (131) may, in embodiments, be the circumferential edge of the wafer (110). Therefore, supporting the edge of the wafer (110), particularly the circumferential edge of the wafer (110), may decrease the contact area between the wafer (110) and the boat support. This may help to reduce contact stress between the wafer (110) and the boat support. This may further allow for reducing the risk for defect formation such as for example, slip formation, in the wafer (110).

In case of warped wafers, that may need to undergo further processing in the boat (170), in the process chamber, the raised portions (150) may provide further the advantage of forming a contact or grip with the warped wafer at its curved edges, which may be concave or convex as schematically shown in Fig. 1b. Therefore, such a boat (170) may further allow for easier handling and easier positioning of the warped wafers in the boat (170).

In embodiments, the raised peripheral portion (150) may have a substantially flat upper surface. The raised peripheral portion (150) may also have substantially rounded peripheral edges. This may provide a sufficient contact between the wafer (110) and the raised peripheral portion (150) thus, allowing to provide support to the wafer (110).

In embodiments, a height of the raised portions (150) may be configured such that a clearance is formed between the wafer and the main portion (151) of the support structures (140) so that the wafer is prevented from coming into contact with the main portion (151) of the upper surface (141) of the support structures (140) when the wafer is placed in the boat (170).

It is to be noted that the height of the raised portions (150) may be a design value that can be optimized depending on the warpage expected to be obtained after the processing in a semiconductor processing apparatus. As such, this may allow for a safer handling of the wafer during transfer from the boat (170).

It is further be noted that the height of the raised portions (150) may be a design value that can be optimized depending on the existing warpage that the wafer may have. This may be advantageous in allowing a safer handling of the wafer during transfer to the boat (170).

In embodiments, the height of the raised peripheral portion (150) may be about 1 mm.

In embodiments, the raised peripheral portion (150) of the wafer support structure (140) of each of the two side boat supports (131) may be aligned substantially 120 degrees with respect to one another and with respect to a third boat support (130) (Fig. 1a). This may allow equibalanced placement of the wafers (110) in the boat (170) and may result in an easy transfer of wafers (110), particularly when dealing with warped wafers. Furthermore, it provides a more improved support to the wafer (110) in the boat (170) since the wafer can be supported at substantially equidistant contact points.

It is however, to be noted that it may be essential to have a gap (g) (Fig. 1a) between the raised portions (150) of each of the wafer support structures and each of the three end effector supports (121) when the center of the end effector is aligned with the center of the three boat supports (130, 131). This may provide the advantage of smooth transfer of the wafer from the end effector (120) to the boat. In the absence of such a gap, the end effector may not fit in the boat support plane (160) and may further collide with the support structure (140) during transfer of the wafer into the boat. Smooth transfer may refer to a minimized wafer movement such that the wafer may be transferred from and to the boat by a minimum number of steps.

Therefore, in some embodiments, the length of the wafer support structures (140) may be configured such that the circumferential edge of the wafer (110) comes in contact with the raised peripheral portions (150) and with the third boat support (130) so that the wafer (110) may be supportable in the boat (170). Thus, the wafer (110) may be supported at its circumferential edge in the boat (170). This may provide the advantage of reducing the risk for particle creation and thus, particle contamination.

Since the peripheral portions (150) of the wafer support structures (140) of the two side boat supports (131) may be raised, the wafer (110) may advantageously be accommodated equibalanced in the boat (170) within the boat support plane (160).

Therefore, the third boat support (130) of the three boat supports may be constructed and arranged to correspond, in height, to the raised peripheral portions (150) of the wafer support structures (150) of the two side boat supports (131). This may provide support to the wafer (110) along its circumferential edge in between the three boat supports.

The correspondence in height of the third boat support (130) with the raised peripheral portions (150) of the wafer support structures (140) of the two side boat supports (131) may be accomplished with respect to a surface of the third boat support (130).

In embodiments, at least a portion of a surface of the third boat support (130), on which a part of the circumferential edge of the wafer rests, may be constructed and arranged to level off, or in other words to be at substantially the same level, with the substantially flat upper surface of the raised peripheral portions (150) of the wafer support structures (140) of the two side boat supports (131). This may allow for each of the plurality of wafers to be accommodated substantially parallel to one another in the boat (170).

In some embodiments, the at least portion of the surface of the third boat support (130) may be an inclined surface. As such, the upper surface of the raised peripheral portions (150) may also have an inclined surface. This may reduce the contact area of the circumferential edge of the wafer with the raised peripheral portions (150) and the surface of the third boat support (130).

Thus, in some embodiments, the third boat support (130) may have a surface inclined (132) towards the center of the three boat supports. This may minimize the contact area of the circumferential edge of the wafer (110) with the third boat support (130). This may then help to reduce contact stress between the wafer and the third boat support (130). The intersection point of the inclined surface (132) with the boat rod (170), in which the circumferential edge of the wafer rests, may thus, be levelling off with the substantially flat upper surface of the raised peripheral portions (150) of the wafer support structures (150) of the two side boat supports (131) to provide equibalanced placement of the wafer (110) in the boat (170).

In embodiments, the two side boat supports (131) may be positioned at a first annular distance from one another around the center of the three boat supports (130,131). Each of the two side boat supports (131) may further be positioned on either side of the third boat support (130) at a second annular distance away from the third boat support (130). The first annular distance may be longer than the second annular distance, thereby allowing the wafer (110) to be supported in the boat (170). This may further allow easy transfer of the wafer (110) to and from the boat (170).

Another aspect of the present disclosure relates to a semiconductor processing apparatus (500). The semiconductor apparatus may be schematically represented in Fig. 3.

The semiconductor apparatus (500) may comprise a process chamber (510) constructed and arranged to receive a plurality of wafers (110). It may also comprise a wafer handling assembly (100) according to embodiments of the first aspect of the present disclosure. The plurality of wafers (110) may be comprised in the boat (170) that may be comprised in the wafer handling assembly (100). The boat may be receivable in the process chamber (510).

The semiconductor apparatus (500) may advantageously allow for processing of warped wafers or of larger sized wafers, such as for example 300 mm or 450 mm wafers. The processing may entail an improved reliability in terms of wafer handling within the semiconductor processing apparatus (500) thanks to the presence of the wafer assembly (100). Improved reliability may refer to reduced wafer damage, reduced wafer breakage or reduced wafer cracking, which may occur, particularly.

In embodiments, the semiconductor processing apparatus (500) may further comprise a temperature controller (540) for adjusting and controlling the temperature of the process chamber (510). This temperature may also be referred to as the process temperature, being the temperature at which the processing in the process chamber (510) takes place.

In embodiments, the semiconductor processing apparatus (500) may further comprise a pressure controller (550). This may allow for adjusting and maintaining the pressure in the process chamber (510) for carrying out the processing in the process chamber (510).

The semiconductor processing apparatus (500) may comprise a gas delivery assembly. The gas delivery assembly may be constructed and arranged for providing the process gas to the semiconductor processing apparatus (500). The gas delivery assembly may comprise a gas injector (560). The gas injector (560) may be constructed and arranged to provide a process gas to the process chamber (510). The provision of the process gas may comprise providing at least one precursor gas to the gas injector (560) directed from a precursor storage module (520). The at least one precursor storage module may thus, be comprised in the gas delivery assembly.

In some embodiments, the semiconductor processing apparatus may comprise two precursor storage modules (520, 570), being different from one another, for providing a first precursor gas and a second precursor gas to the gas injector (560), the first precursor gas being different from the second precursor gas.

In embodiments, the semiconductor processing apparatus (500) may comprise a gas exhaust assembly (530). The gas exhaust assembly (530) may be constructed and arranged for removing an exhaust gas from the semiconductor processing apparatus (500).

In embodiments, the semiconductor processing apparatus (500) may further comprise a controller. The controller may be configured to execute instructions that may be stored in a non-transitory computer readable medium to control processing of the plurality of wafers.

In some embodiments, the controller may be configured to include a processor for executing instructions stored in the non-transitory computer readable medium.

The semiconductor processing apparatus (500) may be a vertical furnace. It may thus, be capable of processing the plurality of wafers that are provided to the process chamber (510) in the boat (170).

In some embodiments, the semiconductor processing apparatus (500) may be a chemical vapor deposition (CVD) apparatus.

In some embodiments, the semiconductor processing apparatus (500) may be a atomic layer deposition (ALD) apparatus.

In a further aspect, the present disclosure relates to a method (1000) of processing a plurality of wafers, as schematically represented in the flow chart in Fig. 4.

The method (1000) may comprise providing (1010) a plurality of wafers (110), in a process chamber (510).

In some embodiments, each of the plurality of wafers may be warped wafers.

In some embodiments, the process chamber (510) may be comprised in a semiconductor processing apparatus (500) as schematically represented in Fig. 3.

The provision (1010) of the plurality of wafers may comprise handling the plurality of wafers (110) using a wafer handling assembly (100) according to embodiments of the first aspect of the present disclosure.

The method (1000) may further comprise providing (1020) a process gas to the process chamber (510), thereby forming a layer on the plurality of wafers (110).

In embodiments, the provision of the process gas may comprise providing a first precursor gas and a second precursor gas to the process chamber (510), the first precursor gas being different from the second precursor gas.

In embodiments, the provision of the process gas may be comprised in a deposition process. The deposition process may, in embodiments, comprise providing the first precursor gas and the second precursor gas to the process chamber (510), thereby forming the layer.

In some embodiments, the provision of the first precursor gas and the provision of the second precursor gas to the process chamber (510) may be done during an overlapping period.

In some embodiments, the provision of the first precursor gas and the provision of the second precursor gas to the process chamber (510) may be done substantially simultaneously. The formation of the layer may thus, be done through a chemical vapor deposition (CVD) process.

In some embodiments, the provision of the first precursor gas and the provision of the second precursor gas that may be comprised in the deposition process may be executed or in other words, repeated, a plurality of times, thereby forming a deposition cycle. During the deposition cycle, the first precursor gas may be provided to the process chamber (510) for a first pulse period that is alternating with the provision of the second precursor gas for a second pulse period. The formation of the layer may thus, be done through an atomic layer deposition (ALD) process.

The deposition process may further comprise removing a portion of the first precursor gas and a portion of the second precursor gas from the process chamber (510). The portion of the first precursor gas and the portion of the second precursor gas that is removed from the process chamber may comprise an unreacted portion of these precursor gases, respectively.

In embodiments, the layer formed may comprise an oxide, a nitride or a carbide.

The embodiments of the present disclosure do not limit the scope of the invention which is only defined by the appended claims.

## Claims

1. A wafer handling assembly (100), comprising:
- a boat (70) constructed and arranged to hold a plurality of wafers (110) and having three boat supports (121) per wafer for supporting the wafer in the boat,
and;
- an end effector (120) comprising three end effector supports for supporting a wafer on the end effector,
wherein the three end effector supports are positioned in substantially the same direction with respect to a center of the three end effector supports as the three boat supports when the center of the end effector is aligned with a center of the three boat supports.

2. The wafer handling assembly according to claim 1, wherein the three end effector supports form an end effector support plane (122) and the three end effector supports are substantially equally separated from one another in said end effector support plane.

3. The wafer handling assembly according to claim 2, wherein the three end effector supports are positioned in directions substantially separated 120 degrees from each other in said end effector support plane with respect to a center of the three end effector supports.

4. The wafer handling assembly according to any one of claims 1 to 3, wherein the three boat supports form a boat support plane (160) and the three end effector supports are substantially equally separated from one another in said boat support plane.

5. The wafer handling assembly according to claim 4, wherein the three boat supports are positioned in directions substantially separated 120 degrees from each other in said boat support plane with respect to a center of the three boat supports.

6. The wafer handling assembly according to any one claims 1 to 5, wherein the three end effector supports are constructed and arranged to support a central portion of the wafer.

7. The wafer handling assembly according to any one of claims 1 to 6, wherein a height of the three end effector supports may be configured such that a clearance is formed between the wafer and the end effector support plane so that the wafer is prevented from coming into contact with the end effector support plane when the wafer is supported on the end effector.

8. The wafer handling assembly according to any one of claims 1 to 7, wherein two of the three boat supports are side boat supports and wherein each of the two side boat supports comprise a wafer support structure (140) having an upper surface (141) with a main portion (151) and a peripheral portion (150), wherein the peripheral portion of the upper surface is raised relative to the main portion for supporting an edge of a wafer.

9. The wafer handling assembly according to claim 8, wherein the raised peripheral portion of the wafer support structure of each of the two side boat supports is aligned substantially at 120° with respect to one another and with respect to the third boat support.

10. The wafer handling assembly according to claim 8 or 9, wherein the raised peripheral portion has a substantially flat upper surface and has substantially rounded peripheral edges.

11. The wafer handling assembly according to any one of claims 8 to 10, wherein a height of the raised peripheral portions may be configured such that a clearance is formed between the wafer and the main portions of the upper surfaces of the support structures so that the wafer is prevented from coming into contact with the main portions of the upper surfaces when the wafer is placed in the boat.

12. The wafer handling assembly according to any one of claims 8 to 11, wherein a length of each of the wafer support structures is configured such that the circumferential edge of the wafer comes in contact with the raised peripheral portions and with the third boat support so that the wafer is supportable in the boat.

13. The wafer handling assembly according to any one of claims 8 to 12, wherein the third boat support of the three boat supports is constructed and arranged to correspond, in height, to the raised peripheral portions of the wafer support structures of the two side boat supports, thereby supporting the wafer along its circumferential edge in between the three boat supports.

14. The wafer handling assembly according to claim 13, wherein the third boat support has a surface inclined towards the center of the three boat supports, thereby minimizing a contact area of the circumferential edge of the wafer with the third boat support.

15. The wafer handling assembly according to any one of claims 8 to 14, wherein the two side boat supports are positioned at a first annular distance from one another around the center of the three boat supports and each is further positioned on either side of the third boat support at a second annular distance away from the third boat support, the first annular distance being longer than the second annular distance, thereby allowing the wafer to be supported in the boat.

16. A semiconductor processing apparatus, comprising:
- a process chamber (510) constructed and arranged to receive a plurality of wafers,
- a wafer handling assembly (100) according to any one of claims 1 to 15, for handling the plurality of wafers.

17. The semiconductor processing apparatus according to claim 16 being a vertical furnace.

18. A method of processing a plurality of wafers, comprising providing a plurality of wafers in a process chamber (510), the provision comprising handling the plurality of wafers using a wafer handling assembly (100) according to any one of claims 1 to 15.

19. The method according to claim 18, wherein the method further comprises providing a process gas to the process chamber, thereby forming a layer on the plurality of wafers.

## Patentansprüche

1. Wafer-Handhabungsanordnung (100), die Folgendes umfasst:
- ein Boot (70), das so konstruiert und angeordnet ist, dass es eine Vielzahl von Wafern (110) halten kann, und das drei Boothalterungen (121) pro Wafer aufweist, um den Wafer in dem Boot zu halten,
und;
- einen Endeffektor (120), der drei Endeffektor-Halterungen zum Halten eines Wafers auf dem Endeffektor umfasst,
wobei die drei Endeffektor-Halterungen im Wesentlichen in derselben Richtung in Bezug auf eine Mitte der drei Endeffektor-Halterungen wie die drei Boothalterungen positioniert sind, wenn die Mitte des Endeffektors mit einer Mitte der drei Boothalterungen ausgerichtet ist.

2. Wafer-Handhabungsanordnung nach Anspruch 1, wobei die drei Endeffektor-Halterungen eine Endeffektor-Halteebene (122) bilden und die drei Endeffektor-Halterungen in der besagten Endeffektor-Halteebene im Wesentlichen gleichmäßig voneinander getrennt sind.

3. Wafer-Handhabungsanordnung nach Anspruch 2, wobei die drei Endeffektor-Halterungen in Richtungen positioniert sind, die in der Endeffektor-Halteebene in Bezug auf eine Mitte der drei Endeffektor-Halterungen im Wesentlichen um 120 Grad voneinander getrennt sind.

4. Wafer-Handhabungsanordnung nach einem der Ansprüche 1 bis 3, wobei die drei Boothalterungen eine Boothalteebene (160) bilden und die drei Endeffektor-Halterungen in der besagten Boothalteebene im Wesentlichen gleichmäßig voneinander beabstandet sind.

5. Wafer-Handhabungsanordnung nach Anspruch 4, bei der die drei Boothalterungen in Richtungen angeordnet sind, die in der Boothalteebene in Bezug auf eine Mitte der drei Boothalterungen im Wesentlichen um 120 Grad voneinander getrennt sind.

6. Wafer-Handhabungsanordnung nach einem der Ansprüche 1 bis 5, wobei die drei Endeffektor-Halterungen so konstruiert und angeordnet sind, dass sie einen mittleren Abschnitt des Wafers halten.

7. Wafer-Handhabungsanordnung nach einem der Ansprüche 1 bis 6, wobei eine Höhe der drei Endeffektor-Halterungen so konfiguriert werden kann, dass ein Zwischenraum zwischen dem Wafer und der Endeffektor-Halteebene gebildet wird, so dass der Wafer daran gehindert wird, mit der Endeffektor-Halteebene in Kontakt zu kommen, wenn der Wafer auf dem Endeffektor gehalten wird.

8. Wafer-Handhabungsanordnung nach einem der Ansprüche 1 bis 7, wobei zwei der drei Boothalterungen seitliche Boothalterungen sind und wobei jede der beiden seitlichen Boothalterungen eine Wafer-Haltestruktur (140) mit einer oberen Fläche (141) mit einem Hauptabschnitt (151) und einem Umfangsabschnitt (150) aufweist, wobei der Umfangsabschnitt der oberen Fläche relativ zum Hauptabschnitt erhöht ist, um eine Kante eines Wafers zu halten.

9. Wafer-Handhabungsanordnung nach Anspruch 8, wobei der erhöhte Umfangsabschnitt der Wafer-Haltestruktur jeder der beiden seitlichen Boothalterungen im Wesentlichen auf 120° zueinander und zur dritten Boothalterung ausgerichtet ist.

10. Wafer-Handhabungsanordnung nach Anspruch 8 oder 9, wobei der erhöhte Umfangsabschnitt eine im Wesentlichen flache obere Fläche und im Wesentlichen abgerundete Umfangskanten aufweist.

11. Wafer-Handhabungsanordnung nach einem der Ansprüche 8 bis 10, wobei eine Höhe der erhöhten Umfangsabschnitte so konfiguriert werden kann, dass ein Zwischenraum zwischen dem Wafer und den Hauptabschnitten der oberen Flächen der Haltestrukturen gebildet wird, so dass der Wafer daran gehindert wird, mit den Hauptabschnitten der oberen Flächen in Kontakt zu kommen, wenn der Wafer in das Boot platziert wird.

12. Wafer-Handhabungsanordnung nach einem der Ansprüche 8 bis 11, wobei eine Länge jeder der Wafer-Haltestrukturen so konfiguriert ist, dass die Umfangskante des Wafers mit den erhöhten Umfangsabschnitten und mit der dritten Boothalterung in Kontakt kommt, so dass der Wafer in dem Boot gehalten werden kann.

13. Wafer-Handhabungsanordnung nach einem der Ansprüche 8 bis 12, wobei die dritte Boothalterung der drei Boothalterungen so konstruiert und angeordnet ist, dass sie in der Höhe den erhöhten Umfangsabschnitten der Wafer-Haltestrukturen der beiden seitlichen Boothalterungen entspricht, wodurch der Wafer entlang seiner Umfangskante zwischen den drei Boothalterungen gehalten wird.

14. Wafer-Handhabungsanordnung nach Anspruch 13, wobei die dritte Boothalterung eine zur Mitte der drei Boothalterungen hin geneigte Fläche aufweist, wodurch eine Kontaktfläche der Umfangskante des Wafers mit der dritten Boothalterung minimiert wird.

15. Wafer-Handhabungsanordnung nach einem der Ansprüche 8 bis 14, wobei die beiden seitlichen Boothalterungen in einem ersten ringförmigen Abstand voneinander um die Mitte der drei Boothalterungen herum angeordnet sind und jede ferner auf jeder Seite der dritten Boothalterung in einem zweiten ringförmigen Abstand von der dritten Boothalterung entfernt angeordnet ist, wobei der erste ringförmige Abstand länger als der zweite ringförmige Abstand ist, wodurch der Wafer in dem Boot gehalten werden kann.

16. Halbleiterverarbeitungsvorrichtung, die Folgendes umfasst:
- eine Prozesskammer (510), die so konstruiert und angeordnet ist, dass sie eine Vielzahl von Wafern aufnehmen kann,
- eine Wafer-Handhabungsanordnung (100) nach einem der Ansprüche 1 bis 15 zum Handhaben der Vielzahl von Wafern.

17. Halbleiterverarbeitungsvorrichtung nach Anspruch 16, die ein Vertikalofen ist.

18. Verfahren zum Verarbeiten einer Vielzahl von Wafern, welches das Bereitstellen einer Vielzahl von Wafern in einer Prozesskammer (510) umfasst, wobei das Bereitstellen das Handhaben der Vielzahl von Wafern unter Verwendung einer Wafer-Handhabungsanordnung (100) gemäß einem der Ansprüche 1 bis 15 umfasst.

19. Verfahren nach Anspruch 18, wobei das Verfahren ferner das Bereitstellen eines Prozessgases in die Prozesskammer umfasst, wodurch eine Schicht auf der Vielzahl von Wafern gebildet wird.

## Revendications

1. Ensemble de manipulation de plaquettes (100),
comprenant :
- -une nacelle (70)
conçu et agencé pour maintenir une pluralité de plaquettes (110)
et
ayant trois supports de nacelle (121) par plaquette pour supporter la plaquette dans la nacelle,
et ;
- un effecteur terminal (120)
comprenant trois supports d'effecteur terminal pour supporter une plaquette sur l'effecteur terminal,
dans lequel les trois supports d'effecteur terminal sont positionnés sensiblement dans la même direction par rapport à un centre des trois supports d'effecteur terminal que les trois supports de nacelle lorsque le centre de l'effecteur terminal est aligné avec un centre des trois supports de nacelle.

2. Ensemble de manipulation de plaquettes selon la revendication 1, dans lequel les trois supports d'effecteur terminal définissent un plan de supports d'effecteur terminal (122) et les trois supports d'effecteur terminal sont sensiblement uniformément espacés les uns des autres dans ledit plan de supports d'effecteur terminal.

3. Ensemble de manipulation de plaquettes selon la revendication 2, dans lequel les trois supports d'effecteur terminal sont positionnés dans des directions sensiblement séparées de 120 degrés les unes des autres dans ledit plan de supports d'effecteur terminal par rapport à un centre des trois supports d'effecteur terminal.

4. Ensemble de manipulation de plaquettes selon l'une quelconque des revendications 1 à 3,
dans lequel les trois supports de nacelle définissent un plan de supports de nacelle (160) et les trois supports d'effecteur terminal sont sensiblement uniformément espacés les uns des autres dans ledit plan de supports de nacelle.

5. Ensemble de manipulation de plaquettes selon la revendication 4, dans lequel les trois supports de nacelle sont positionnés dans des directions sensiblement séparées de 120 degrés les unes des autres dans ledit plan de supports de nacelle par rapport à un centre des trois supports de nacelle.

6. Ensemble de manipulation de plaquettes selon l'une quelconque des revendications 1 à 5,
dans lequel les trois supports d'effecteur terminal sont conçus et agencés pour supporter une partie centrale de la plaquette.

7. Ensemble de manipulation de plaquettes selon l'une quelconque des revendications 1 à 6,
dans lequel une hauteur des trois supports d'effecteur terminal peut être configurée de sorte qu'un jeu soit formé entre la plaquette et le plan de supports d'effecteur terminal de manière à empêcher la plaquette d'entrer en contact avec le plan de supports d'effecteur terminal lorsque la plaquette est supportée sur l'effecteur terminal.

8. Ensemble de manipulation de plaquettes selon l'une quelconque des revendications 1 à 7,
dans lequel deux des trois supports de nacelle sont des supports latéraux de nacelle et dans lequel chacun des deux supports latéraux de nacelle comprend une structure de support de plaquette (140) ayant une surface supérieure (141) avec une partie principale (151) et une partie périphérique (150),
dans lequel la partie périphérique de la surface supérieure est surélevée par rapport à la partie principale pour supporter un bord d'une plaquette.

9. Ensemble de manipulation de plaquettes selon la revendication 8, dans lequel la partie périphérique surélevée de la structure de support de plaquettes de chacun des deux supports latéraux de nacelle est alignée sensiblement à 120° l'une par rapport à l'autre et par rapport au troisième support de nacelle.

10. Ensemble de manipulation de plaquettes selon la revendication 8 ou 9, dans lequel la partie périphérique surélevée a une surface supérieure sensiblement plane et présente des bords périphériques sensiblement arrondis.

11. Ensemble de manipulation de plaquettes selon l'une quelconque des revendications 8 à 10, dans lequel une hauteur des parties périphériques surélevées peut être configurée de sorte qu'un jeu soit formé entre la plaquette et les parties principales des surfaces supérieures des structures de support de manière à empêcher la plaquette d'entrer en contact avec les parties principales des surfaces supérieures lorsque la plaquette est placée dans la nacelle.

12. Ensemble de manipulation de plaquettes selon l'une quelconque des revendications 8 à 11, dans lequel une longueur de chacune des structures de support de plaquettes est configurée de sorte que le bord circonférentiel de la plaquette entre en contact avec les parties périphériques surélevées et avec le troisième support de nacelle de sorte que la plaquette puisse être supportée dans la nacelle.

13. Ensemble de manipulation de plaquettes selon l'une quelconque des revendications 8 à 12, dans lequel le troisième support de nacelle des trois supports de nacelle est conçu et agencé pour correspondre, en hauteur, aux parties périphériques surélevées des structures de support de plaquettes des deux supports latéraux de nacelle, supportant ainsi la plaquette le long de son bord circonférentiel entre les trois supports de nacelle.

14. Ensemble de manipulation de plaquettes selon la revendication 13, dans lequel le troisième support de nacelle a une surface inclinée vers le centre des trois supports de nacelle, minimisant ainsi une zone de contact du bord circonférentiel de la plaquette avec le troisième support de nacelle.

15. Ensemble de manipulation de plaquettes selon l'une quelconque des revendications 8 à 14, dans lequel les deux supports latéraux de nacelle sont positionnés à une première distance annulaire l'un de l'autre autour du centre des trois supports de nacelle et chacun est en outre positionné de part et d'autre du troisième support de nacelle à une deuxième distance annulaire du troisième support de nacelle, la première distance annulaire étant plus grande que la deuxième distance annulaire, permettant ainsi de supporter la plaquette dans la nacelle.

16. Appareil de traitement de semi-conducteurs, comprenant :
- -une chambre de procédé (510) conçue et agencée pour recevoir une pluralité de plaquettes,
- un ensemble de manipulation de plaquettes (100) selon l'une quelconque des revendications 1 à 15, pour manipuler la pluralité de plaquettes.

17. Appareil de traitement de semi-conducteurs selon la revendication 16 constituant un four vertical.

18. Procédé de traitement d'une pluralité de plaquettes, comprenant la fourniture
d'une pluralité de plaquettes dans une chambre de procédé (510), ladite fourniture comprenant la manipulation
de la pluralité de plaquettes à l'aide d'un ensemble de manipulation de plaquettes (100) selon l'une quelconque des revendications 1 à 15.

19. Procédé selon la revendication 18, dans lequel le procédé comprend en outre la délivrance d'un gaz de procédé vers la chambre de procédé, formant ainsi une couche sur la pluralité de plaquettes.
